# EUROPÄISCHE PATENTSCHRIFT

(11) **EP 2 510 586 B1**
(45) Veröffentlichungstag und Bekanntmachung des Hinweises auf die Patenterteilung: **27.02.2019**
(21) Anmeldenummer: 10809224.8
(22) Anmeldetag: 03.12.2010
(51) Int. Cl.: H01R 12/58, H01R 12/72, H05K 1/02, H05K 3/30, H01R 13/6587

(54) **RELIEF-STECKVERBINDER UND MULTILAYERPLATINE**
RELIEF PLUG-IN CONNECTOR AND MULTILAYER CIRCUIT BOARD
CONNECTEUR EN RELIEF ET CARTE DE CIRCUITS IMPRIMÉS MULTICOUCHE

(30) Priorität: 08.12.2009 DE 102009057260
(43) Veröffentlichungstag der Anmeldung: 17.10.2012
(73) Patentinhaber: ERNI Production GmbH & Co. KG, 73099 Adelberg (DE)
(72) Erfinder: MÖDINGER, Roland, 71384 Weinstadt (DE)
(74) Vertreter: Jakelski & Althoff Patentanwälte PartG mbB
(86) Internationale Anmeldenummer: PCT/DE2010/001405
(87) Internationale Veröffentlichungsnummer: WO 2011/069485

(56) Entgegenhaltungen:
- WO-A1-2010/011255
- US-A- 5 961 349
- US-A1- 2005 239 300
- US-A1- 2007 296 066
- US-A1- 2008 176 452
- US-A1- 2009 045 889
- US-B1- 7 337 537

## Beschreibung

### Stand der Technik

Die Erfindung geht aus von einem mehrpoligen Relief-Steckverbinder zur Kontaktierung mit einer Multilayerplatine, von einer Multilayerplatine zur Bestückung mit einem mehrpoligen Relief-Steckverbinder und von einer Kombination aus einem mehrpoligen Relief-Steckverbinder und einer zur Bestückung mit dem mehrpoligen Relief-Steckverbinder vorgesehenen Multilayerplatine.

Die Erfindung betrifft weiterhin ein Herstellungsverfahren für die Multilayerplatine.

Aus der US 2005/0239300 A1 geht ein elektrischer Verbinder hervor, bei dem die Kontakte stufenförmig angeordnet sind.

Die US 2008/0176452 A1 offenbart einen mehrpoligen Steckverbinder mit einer Mehrzahl von Kontaktelementen, deren Kontaktierungs-Abschnitte in höhenversetzten Kontaktbereichflächen angeordnet sind. Die Kontaktelemente im Kontaktierungs-Abschnitt sind als Einpress-Kontakte ausgebildet. Der beim Einpressen deformierbare federnde Bereich ist bei allen Kontakten etwa in gleicher Höhe angeordnet.

Ein Verfahren zur Erzeugung von Durchgangslöchern in Leiterplatten geht beispielsweise aus der US 7,337,537 B1 hervor.

Die US 2009/0045889 A1 offenbart eine High-Speed Router Backplane.

Aus der Patentschrift US 5 543 586 A ist eine als Multilayerplatine realisierte Backplane bekannt geworden, die mit Stiften von Kontaktelementen verlötet werden kann. Die Kontaktelemente können zu Vierergruppen zusammengefasst sein. Die einzelnen Kontaktelemente der Vierergruppen können sowohl auf einer einzigen Schicht der Multilayerplatine als auch auf weiter unten liegenden Schichten der Multilayerplatine verlötet sein.

In der Patentschrift US 7 278 855 B2 ist eine Backplane beschrieben, die als Multilayerplatine realisiert ist. Die Platine kann mehrere Kontaktbereich-Flächen für Kontaktelemente aufweisen, beispielsweise eine erste Kontaktbereich-Fläche in der Mitte der Backplane und eine zweite Kontaktbereich-Fläche am Rand der Backplane.

Die Patentschrift US 7 192 320 B2 sowie die Offenlegungsschrift US 2009/0093173 A1 beschreiben eine Multilayerplatine, die ebenfalls mehrere Kontaktbereich-Flächen aufweisen kann, wobei die Kontaktbereich-Flächen auf einzelnen Schichten der Multilayerplatine vorgesehen sind, sodass die Kontaktbereich-Flächen eine treppenförmige Struktur bilden. Hierbei ist beispielsweise ein im mittleren Bereich der Platine angeordneter Kontaktbereich mit beidseitig treppenförmigen Ausgestaltungen und ein am Rand angeordneter Kontaktbereich mit einer einseitig treppenförmigen Ausgestaltung vorgesehen. Die Kontaktbereiche können mit ausschließlich fallenden oder steigenden, aber auch sowohl steigenden als auch fallenden Treppen realisiert sein. Unterschiedliche Kontaktbereiche können über Kabel verbunden werden, die korrespondierende stufenförmig angeordnete Kontaktbereiche zur Kontaktierung der in der Backplane vorgesehenen stufenförmigen Kontaktbereiche aufweisen. Beschrieben sind weiterhin Relief-Steckverbinder, die zur Kontaktierung von auf den Kontaktbereich-Flächen angeordneten Kontaktflächen vorgesehen sind. Die Kontaktierungs-Abschnitte der Kontaktelemente des Relief-Steckverbinders werden auf die auf den Kontaktbereich-Flächen angeordneten Kontaktflächen zur Herstellung des Kontakts gedrückt. Die Kontaktierungs-Abschnitte der Kontaktelemente können alternativ auch mit den auf den einzelnen Treppen angeordneten Kontaktflächen verlötet werden.

In der Patentschrift DE 699 15 882 T2 ist ein Steckverbinder beschrieben, der für eine hochfrequente Datenübertragung geeignet ist. Jedem Signal führenden Kontaktelement ist ein Abschirm- beziehungsweise Massepotenzial führendes Kontaktelement zugeordnet. Die Ausrichtung der Kontaktelemente ist derart getroffen, dass eine Impedanz-Anpassung ermöglicht wird.

In der Patentschrift US 6 976 886 B2 ist ein Steckverbinder beschrieben, bei dem durch eine spezielle Anordnung und Ausrichtung der Signal führenden und Abschirm- beziehungsweise Massepotenzial führenden Kontaktelemente zueinander eine hohe Abschirmwirkung der Signal führenden Leitungen gegeneinander und des Steckverbinders insgesamt erreicht werden soll. Der bekannte Steckverbinder ist speziell für hochfrequente Signale geeignet, wobei die Anordnung der Signal führenden und Massepotenzial führenden Kontaktelemente darüber hinaus zur Erzielung eines bestimmten Wellenwiderstands speziell vorgegeben ist.

In der Offenlegungsschrift DE 198 07 713 A1 ist ein Steckverbinder beschrieben, der eine große Anzahl von Kontaktelementen enthält. Der bekannte Steckverbinder ist zum Herstellen von Steckverbindungen zwischen Backplanes und Einschubkarten vorgesehen, wobei im konkreten Ausführungsbeispiel Steckverbindungen zwischen Backplanes und Einschubkarten sogenannter Compact-PCI-Systeme hergestellt werden.

In dem Fachbuch von Meinke und Gundlach "Taschenbuch für Hochfrequenztechnik", Springer-Verlag 1956, Seiten 6 - 15, 48 - 49 und 158 - 169 sind Grundbegriffe der Elektrotechnik wie Kapazität, Induktivität und Wellenwiderstand erläutert.
Der Erfindung liegt die Aufgabe zugrunde, einen mehrpoligen Relief-Steckverbinder zur Kontaktierung mit einer Multilayerplatine, eine Multilayerplatine zur Bestückung mit einem mehrpoligen Relief-Steckverbinder, eine Kombination aus einem mehrpoligen Relief-Steckverbinder und einer zur Bestückung mit dem mehrpoligen Relief-Steckverbinder vorgesehenen Multilayerplatine sowie ein Herstellungsverfahren für die Multilayerplatine jeweils anzugeben, die eine zuverlässige Kontaktierung bei geringen Fertigungskosten ermöglichen.
Die Aufgaben werden durch die in den unabhängigen Ansprüchen angegebenen Merkmale jeweils gelöst.

### Offenbarung der Erfindung

Der mehrpolige Relief-Steckverbinder nach Anspruch 1 zur Kontaktierung mit einer Multilayerplatine geht von einer Mehrzahl von Kontaktelementen aus, die in höhenversetzten Kontaktbereich-Flächen angeordnet sind. Der erfindungsgemäße Relief-Steckverbinder zeichnet sich dadurch aus, dass die Kontaktierungs-Abschnitte der Kontaktelemente als Einpress-Kontakte zum Einpressen in Einpress-Kontakt-Aufnahmen einer Multilayerplatine ausgebildet sind.
Der erfindungsgemäße Relief-Steckverbinder kann mit der erfindungsgemäß vorgesehenen Maßnahme besonders einfach und insbesondere kostengünstig mit der Multilayerplatine kontaktiert werden. Eine bisher vorgesehene Verlötung und die damit einhergehende thermische Belastung sowohl der Relief-Steckverbinder als auch der Multilayerplatinen entfallen vollständig.

Die Einpress-Kontakte können besonders einfach durch Stanzen herstellt werden, wobei ein federndes Element im Kontaktierungs-Abschnitt entsteht, das den Einpress-Kontakt bildet.
Die Kontaktierungs-Abschnitte der Kontaktelemente sind gleich lang ausgebildet. Die einheitliche Ausgestaltung ermöglicht eine besonders rationelle Fertigung der Einpress-Kontakte.
Die Einpress-Kontakte sind nebeneinander in einer gedachten Verbindungslinie angeordnet und bilden vorzugsweise jeweils benachbart angeordnete Signal-Einpress-Kontaktpaare. Durch die entstehende symmetrische Struktur sind die Signal-Einpress-Kontaktpaare besonders zur Führung von Differenzsignalen geeignet.
Den Einpress-Kontaktpaaren ist dabei wenigstens ein benachbart angeordneter Abschirm-Einpress-Kontakt zugeordnet, wobei der wenigstens eine Abschirm-Einpress-Kontakt in Bezug auf die jeweils zugeordneten Signal-Einpress-Kontaktpaare seitlich versetzt angeordnet ist, derart, dass er nicht auf der Signal-Einpress-Kontaktpaar-Verbindungslinie liegt.
Die dadurch entstehende Struktur kann durch vorgegebene geometrische Verhältnisse und unter Einbeziehung des vorgesehenen Dielektrikums wenigstens näherungsweise mit einem vorgegebenen Wellenwiderstand realisiert werden. Erzielt wird eine hohe Signalintegrität, wodurch der erfindungsgemäße Relief-Steckverbinder insbesondere zur Führung von hochfrequenten Signalen bis weit in den GHz-Bereich geeignet ist.

Die erfindungsgemäße Multilayerplatine nach Anspruch 2 zur Bestückung mit einem mehrpoligen Relief-Steckverbinder geht davon aus, dass die Multilayerplatine mehrere höhenversetzte Kontaktbereich-Flächen aufweist. Die erfindungsgemäße Multilayerplatine zeichnet sich dadurch aus, dass in den Kontaktbereich-Flächen jeweils Kontakt-Aufnahmen angeordnet sind, die als Einpress-Kontakt-Aufnahmen ausgebildet sind.
Die erfindungsgemäße Multilayerplatine ist speziell zur Bestückung mit dem erfindungsgemäßen Steckverbinder geeignet ausgestaltet.
In die Einpress-Kontakt-Aufnahmen sind elektrisch leitfähige Hülsen zur elektrischen Kontaktierung mit den Einpress-Kontakten der Relief-Steckverbinder eingebracht. Die Hülsen sind mechanisch besonders robust und ermöglichen sowohl eine sichere mechanische als auch elektrische Kontaktierung.
Wenigstens einige Hülsen erstrecken sich über die gesamte Höhe der Multilayerplatine. Die vergleichsweise große elektrisch leitfähige Fläche führt zu einer guten Abschirmwirkung, weshalb die diese Hülsen zur Kontaktierung mit den Abschirm-Einpress-Kontakten des Relief-Steckverbinders vorgesehen sind.
Die Längen der Hülsen sind dabei auf vorgegebene Werte festgelegt. Die Hülsen sind zur Kontaktierung mit Signal-Einpress-Kontaktpaaren vorgesehen, wobei die symmetrische Leitungsführung im Vordergrund steht. Die kurzen Hülsen minimieren die unerwünschten, zwischen den Einpress-Kontaktaufnahmen auftretenden Kapazitäten.

Die erfindungsgemäße Kombination nach Anspruch 3 aus wenigstens einem mehrpoligen Relief-Steckverbinder und einer Multilayerplatine geht davon aus, dass der Relief-Steckverbinder eine Vielzahl von Kontaktelementen aufweist, deren Kontaktierungs-Abschnitte in höhenversetzten Kontaktbereichs-Flächen angeordnet sind, und dass die Multilayerplatine ebenfalls mehrere höhenversetzte Kontaktbereichs-Flächen aufweist. Die Kombination zeichnet sich dadurch aus, dass die Kontaktelemente des Relief-Steckverbinders im Kontaktierungs-Abschnitt als Einpress-Kontaktelemente zum Einpressen in Einpress-Kontakt-Aufnahmen der Multilayerplatine ausgebildet sind und dass in den Kontaktbereichs-Flächen der Multilayerplatine Kontakt-Aufnahmen angeordnet sind, die als Einpress-Kontakt-Aufnahmen ausgebildet sind.
Die erfindungsgemäße Kombination vereint die bereits beschriebenen Vorteile der einzelnen Komponenten der Kombination.

Das weiterhin vorgesehene erfindungsgemäße Verfahren nach Anspruch 4 zur Herstellung einer Multilayerplatine zur Bestückung mit wenigstens einem Relief-Steckverbinder, wobei die Multilayerplatine mehrere höhenversetzte Kontaktbereich-Flächen aufweist, sieht vor, dass in den Kontaktbereich-Flächen Einpress-Kontakt-Aufnahmen angeordnet werden, die mittels Bohrungen hergestellt werden, dass elektrisch leitfähige Hülsen in die Bohrungen eingebracht werden, dass die Hülsen von der Bestückungsseite der Multilayerplatine auf die Höhen der jeweils vorgesehenen Kontaktbereich-Flächen ausgebohrt werden und dass anschließend die in unterschiedlichen Höhen liegenden Kontaktbereich-Flächen der Multilayerplatine hergestellt werden.
Das erfindungsgemäße Herstellungsverfahren ermöglicht eine rationelle Fertigung der erfindungsgemäßen Multilayerplatine.
Eine Ausgestaltung des erfindungsgemäßen Herstellungsverfahrens sieht vor, dass zumindest einige Hülsen zusätzlich von der Rückseite der Multilayerplatine entgegen der Bestückungsrichtung der Multilayerplatine ausgebohrt werden, sodass die Hülsen eine vorgegebene Länge aufweisen, die geringer als die Höhe der jeweiligen Kontaktbereich-Fläche der Multilayerplatine ist. Diese Vorgehensweise wird insbesondere bei den Hülsen angewandt, die zur Kontaktierung mit den Signal-Einpress-Kontaktpaaren vorgesehen sind.
Weitere vorteilhafte Weiterbildungen und Ausgestaltungen des erfindungsgemäßen Relief-Steckverbinders, der erfindungsgemäßen Multilayerplatine, der Kombination aus Relief-Steckverbinder und Multilayerplatine sowie des erfindungsgemäßen Herstellungsverfahrens der Multilayerplatine ergeben sich aus der folgenden Beschreibung.

### Kurzbeschreibung der Figuren

Es zeigen
- Figur 1: eine Ansicht von erfindungsgemäßen Relief-Steckverbindern vor der Kontaktierung mit erfindungsgemäßen Multilayerplatinen,
- Figur 2: einen Längsschnitt durch eine erfindungsgemäße Multilayerplatine, die mit einem als Federleiste ausgestalteten erfindungsgemäßen Relief-Steckverbinder kontaktiert ist,
- Figur 3: einen Längsschnitt durch eine erfindungsgemäße Multilayerplatine, die mit einem als Messerleiste ausgestalteten erfindungsgemäßen Relief-Steckverbinder kontaktiert ist,
- Figur 4: eine Detailansicht im Bereich der Kontaktierung einer mehrfach geschnitten erfindungsgemäßen Multilayerplatine, die mit einem erfindungsgemäßen Relief-Steckverbinder bestückt ist,
- Figur 5: einen ersten Schritt eines erfindungsgemäßen Herstellungsverfahrens einer erfindungsgemäßen Multilayerplatine,
- Figur 6: einen zweiten Schritt eines erfindungsgemäßen Herstellungsverfahrens einer erfindungsgemäßen Multilayerplatine,
- Figur 7: eine erste Ausgestaltung von Kontaktbereich-Flächen einer erfindungsgemäßen Multilayerplatine und
- Figur 8: eine zweite Ausgestaltung von Kontaktbereich-Flächen einer erfindungsgemäßen Multilayerplatine.

### Beschreibung der Ausführungsbeispiele

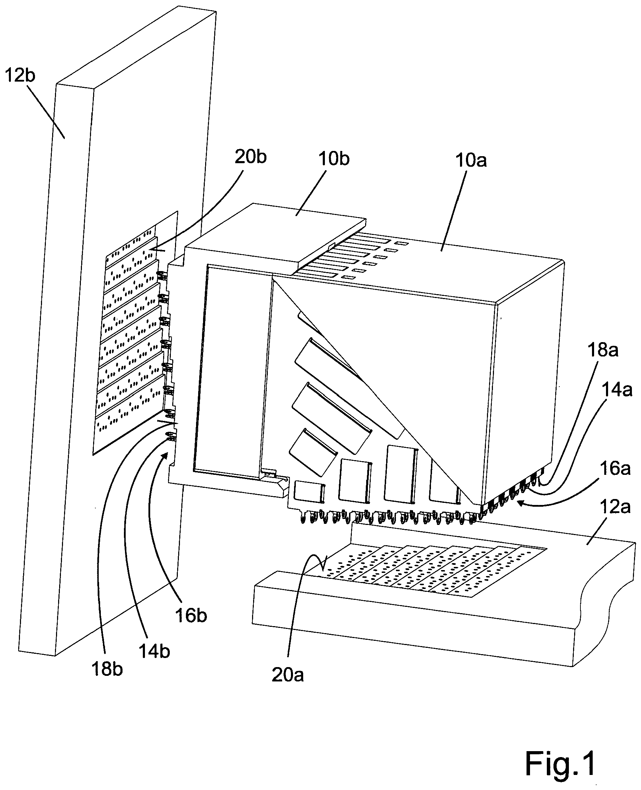

Figur 1 zeigt eine Ansicht von erfindungsgemäßen Relief-Steckverbindern 10a, 10b vor der Kontaktierung mit erfindungsgemäßen Multilayerplatinen 12a, 12b. Hierbei ist ein erfindungsgemäßer Relief-Steckverbinder 10a als Federleiste und ein korrespondierender Relief-Steckverbinder 10b als Messerleiste realisiert, die beide im gesteckten Zustand dargestellt sind. Die Multilayerplatine 12a ist beispielsweise als Tochterkarte und die Multilayerplatine 12b als Backplane realisiert.

Die erfindungsgemäßen Relief-Steckverbinder 10a, 10b weisen jeweils eine Vielzahl von Kontaktelementen 14a, 14b auf, deren Kontaktierungs-Abschnitte 16a, 16b in jeweils höhenversetzt angeordneten Kontaktbereich-Flächen 18a, 18b angeordnet sind.

Die erfindungsgemäßen Multilayerplatinen 12a, 12b weisen jeweils den Kontaktbereich-Flächen 18a, 18b der Relief-Steckverbinder 10a, 10b entsprechende Kontaktbereich-Flächen 20a, 20b auf.

Die jeweils höhenversetzt angeordneten Kontaktbereich-Flächen 18a, 18b, 20a, 20b bilden treppenförmige Anordnungen, die den optischen Eindruck eines Reliefs erwecken, weshalb die Steckverbinder 10a, 10b als Relief-Steckverbinder 10a, 10b bezeichnet sind.

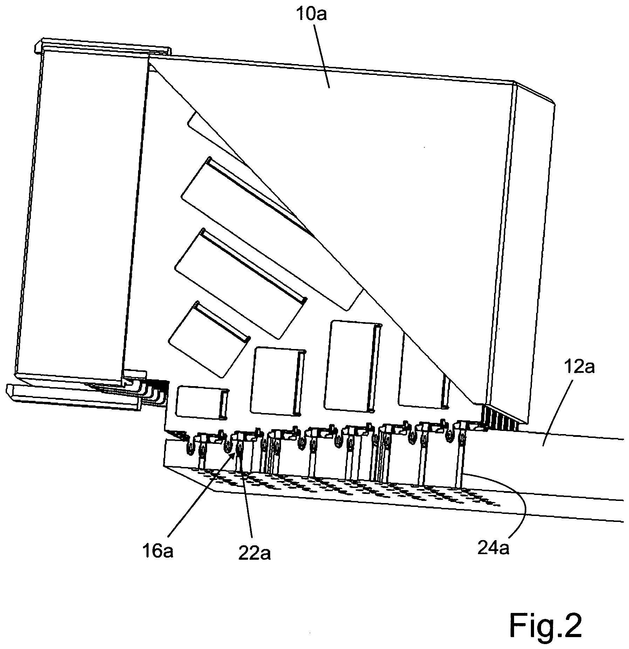

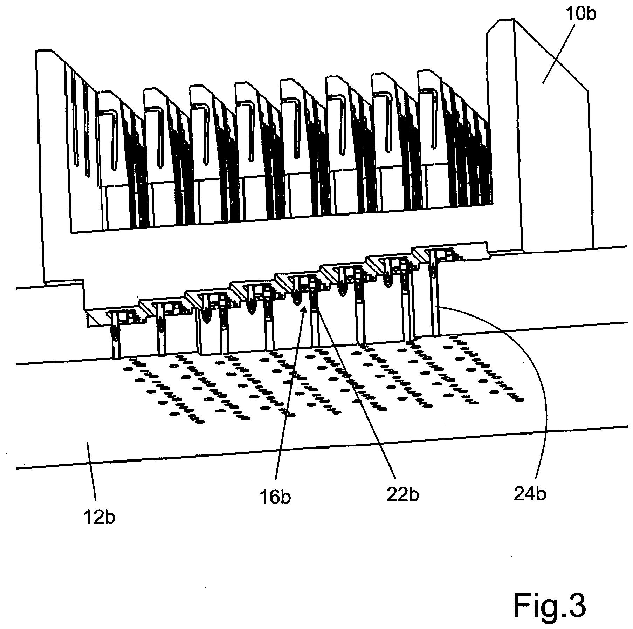

Figur 2 zeigt einen Längsschnitt durch die erfindungsgemäße Multilayerplatine 12a, 12b, die mit dem als Federleiste ausgestalteten erfindungsgemäßen Relief-Steckverbinder 10a kontaktiert ist und Figur 3 zeigt einen Längsschnitt durch die erfindungsgemäße Multilayerplatine 12b, die mit dem als Messerleiste ausgestalteten erfindungsgemäßen Relief-Steckverbinder 10b kontaktiert ist. Beide Schnitte durch die Multilayerplatine 12a, 12b zeigen, dass die Kontaktierungs-Abschnitte 16a, 16b der Relief-Steckverbinder 10a, 10b erfindungsgemäß als Einpress-Kontakte 22a, 22b realisiert sind.

Diejenigen in den Figuren 2 und 3 gezeigten Teile, die mit den in Figur 1 gezeigten Teilen übereinstimmen, tragen jeweils dieselben Bezugszeichen. Diese Vereinbarung gilt auch für die nachfolgenden Figuren.

Die Einpress-Kontakte 22a, 22b sind in entsprechende Einpress-Kontakt-Aufnahmen 24a, 24b in der Multilayerplatine 12a, 12b im kontaktierten Zustand eingepresst.

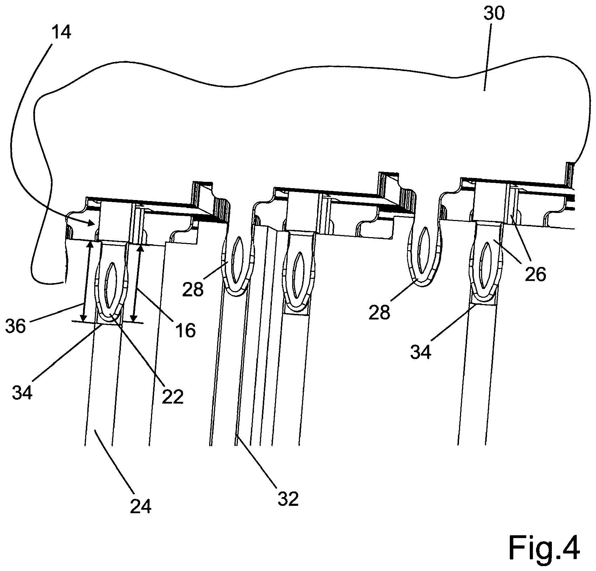

Figur 4 zeigt eine stark vergrößerte Darstellung der Einpress-Kontakte 22, wobei Figur 4 exemplarisch die Kombination des erfindungsgemäßen Relief-Steckverbinders 10 mit der erfindungsgemäßen Multilayerplatine 12 wiedergibt. Die Unterscheidung zwischen den Bezugszeichen-Ergänzungen "a" und "b" entfällt. Die Beschreibung soll jedoch durchgehend sowohl für den als Federleiste ausgestalteten Steckverbinder 10a, dessen Komponenten mit der Bezugszeichen-Ergänzung "a" bezeichnet sein sollen, als auch für den als Messerleiste ausgestalteten Steckverbinder 10b gelten, dessen Komponenten mit der Bezugszeichen-Ergänzung "b" bezeichnet sein sollen. Diese Vereinbarung gilt auch für die folgenden Figuren beziehungsweise die weitere Beschreibung sinngemäß.

Die Einpress-Kontakte 22 können beispielsweise durch Stanzen hergestellt werden, wobei ein federndes Element entsteht, das in die Einpress-Kontakt-Aufnahme 24 der Multilayerplatine 12 eingepresst werden kann.

Figur 4 zeigt eine Ausgestaltung, bei der die Kontaktierungs-Abschnitte 16 der Einpress-Kontakte 22 gleiche Länge aufweisen. Mit dieser Ausgestaltung können die Kontaktelemente 14 mit den Einpress-Kontakten 22 im Rahmen einer Serienfertigung kostengünstig gefertigt werden.

Figur 4 zeigt eine weitere Ausgestaltung, gemäß der Signal-Einpress-Kontaktpaare 26 vorgesehen sind, die benachbart mit einem vorzugsweise vorgegebenen Abstand voneinander angeordnet sein können. Weiterhin können Abschirm-Einpress-Kontakte 28 vorgesehen sein, die beispielsweise zur Kontaktierung von elektrisch leitendenden, im Steckverbinder 10 vorhandenen Abschirmlamellen 30 vorgesehen sind. Selbstverständlich können zusätzlich oder anstelle von Signal-Einpress-Kontaktpaaren 26 auch einzelne Signal-Einpress-Kontakte vorgesehen sein.

Die elektrische Kontaktierung in den Einpress-Kontakt-Aufnahmen 24 wird beispielsweise mittels elektrisch leitfähigen Hülsen 32, 34 hergestellt. Dargestellt ist eine vorteilhafte Ausgestaltung, bei welcher die den Signal führenden Kontaktelementen 14, beispielsweise den Signal-Einpress-Kontaktpaaren 26 kürzere Hülsen 34 und den Abschirm-Einpress-Kontakten 28 längere Hülsen 32 zugeordnet sein können. Die Hülsen 32, 34 weisen daher vorgegebene Längen 36 auf.

Die Signal-Einpress-Kontaktpaare 26 ermöglichen eine symmetrische Leitungsführung nicht nur innerhalb des Steckverbinders 10, sondern insbesondere auch im Kontaktierungs-Abschnitt 16 der Einpress-Kontakte 22, 26, 28 beziehungsweise in den Einpress-Kontakt-Aufnahmen 24. Damit lassen sich äußerst geringe Laufzeitdifferenzen zwischen den Signalen realisieren. Besonders wesentlich sind geringe Laufzeitdifferenzen, wenn die Signal-Einpress-Kontaktpaare 26 Differenzsignale führen, beispielsweise digitale Signale im Bereich bis 40 Gbit/s, die noch fehlerfrei mit einem möglichst weit geöffneten Augenmuster übertragen werden sollen.

Hierbei spielt die Vorgabe eines bestimmten differenziellen Wellenwiderstands, beispielsweise 100 Ohm, für ein Signal-Einpress-Kontaktpaar 26 eine Rolle, wobei der Wellenwiderstand, dessen Definition dem bereits eingangs genannten Fachbuch von Meincke und Gundlach entnommen werden kann, durch die geometrische Ausgestaltung der Kontaktelemente 14, also deren Form und Abstand zueinander, sowie durch das zwischen dem Signal-Einpress-Kontaktpaar 26 vorhandene Dielektrikum wesentlich beeinflusst wird. Bedeutung kommt auch dem Abschirm-Einpress-Kontakt 28 zu, der zusammen mit der Abschirmlamelle 30 eine hohe Signalintegrität sicherstellt.

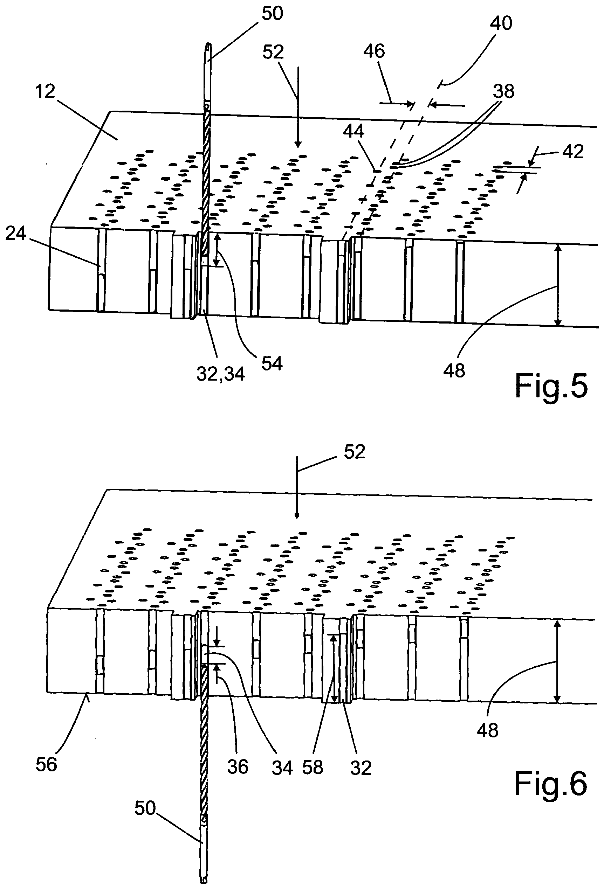

Geometrische Beziehungen betreffend Signal-Einpress-Kontaktpaare 26 und Abschirm-Einpress-Kontakt 28 werden in der folgenden Figur 5 verdeutlicht, anhand der weiterhin die ersten Schritte des erfindungsgemäßen Herstellungsverfahrens der Multilayerplatine 12a, 12b erläutert werden.

Figur 5 verdeutlicht die Anordnung der nicht dargestellten Signal-Einpress-Kontaktpaare 26 anhand der Anordnung der zugehörenden Einpress-Kontakt-Aufnahmen 38. Ein oder vorzugsweise mehrere Signal-Einpress-Kontaktpaare 26 werden auf einer gedachten Verbindungslinie 40 benachbart nebeneinander angeordnet. Vorzugsweise ist zwischen einzelnen Signal-Einpress-Kontakten der Signal-Einpress-Kontaktpaare 26 jeweils ein vorgegebener Abstand 42 vorgesehen.

Die nicht dargestellten Abschirm-Einpress-Kontakte 28 beziehungsweise die entsprechenden Abschirm-Einpress-Kontakt-Aufnahmen 44 liegen vorzugsweise mit einem Versatz 46 neben der Verbindungslinie 40. Vorzugsweise sind mehrere Abschirm-Einpress-Kontakt-Aufnahmen 44 vorgesehen, die dann ebenfalls vorzugsweise auf einer gedachten Verbindungslinie angeordnet sind.

Das Herstellungsverfahren geht von einer Multilayerplatine 12 mit einer bestimmten Höhe 48 aus. Die Einpress-Kontakt-Aufnahmen 24, 38, 44 werden mittels eines Bohrers 50 in Bestückungsrichtung 52 durch die gesamte Höhe 48 der Multilayerplatine 12 gebohrt. Anschließend werden die Hülsen 32, 34 in den Einpress-Kontakt-Aufnahmen 24, 38, 44 vorzugsweise durch ein galvanisches Abscheidungsverfahren hergestellt. Von der Bestückungsseite werden dann die Hülsen 32, 34 mindestens bis auf eine Höhe 54 ausgebohrt, die später der Höhe 54 der betreffenden Kontaktbereich-Fläche 20 wenigstens näherungsweise entsprechen kann.

Im nachfolgenden Bearbeitungsschritt, der in Figur 6 gezeigt ist, können von der Rückseite 56 der Multilayerplatine 12 wenigstens einige Hülsen 34 entgegen der Bestückungsrichtung 52 bis auf die vorgegebene Länge 36 ausgebohrt werden. In diese Hülsen 34 werden später vorzugsweise die Signal führenden Einpress-Kontakte 22, 26 eingepresst. Durch das Kürzen der Hülsen 34 werden die unerwünschten zwischen den Einpress-Kontaktaufnahmen 38 auftretenden Kapazitäten reduziert.

Einige Hülsen 32 werden von der Rückseite her nicht ausgebohrt. In diese Hülsen 32, deren Höhe 58 später der Höhe der Kontaktbereich-Fläche 20 wenigstens näherungsweise entspricht, werden später vorzugsweise die Abschirm-Einpress-Kontakte 28 eingepresst. Die größere metallische Fläche der ungekürzten Hülsen 32 unterstützt die Abschirmwirkung.

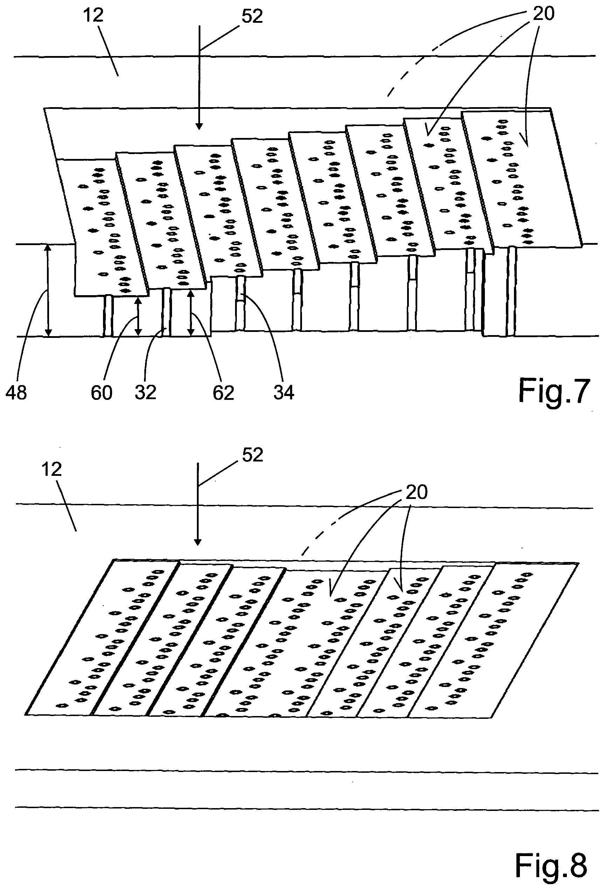

Im letzten Bearbeitungsschritt werden die Kontaktbereich-Flächen 20 in den verschiedenen Höhen 58 der Multilayerplatine 12 vorzugsweise durch Abfräsen hergestellt. Die Figuren 7 und 8 zeigen zu diesem Herstellungsschritt verschiedene Möglichkeiten zur Realisierung der Kontaktbereich-Flächen 20. Gemäß Figur 7 ist eine ständig ansteigende beziehungsweise ständig abfallende Treppe vorgesehen. Eingetragen sind weitere unterschiedliche Höhen 60, 62. Gezeigt sind im Schnittbild weiterhin eine kurze Hülse 32 sowie eine lange Hülse 34. Gemäß Figur 8 ist eine sowohl ansteigende als auch abfallende Treppe gezeigt.

## Patentansprüche

1. Mehrpoliger Relief-Steckverbinder zur Kontaktierung mit einer Multilayerplatine (12a, 12b), der eine Vielzahl von Kontaktelementen (14a, 14b), die senkrecht aus den Stufen eines treppenförmigen Reliefs herausragen, aufweist, so dass deren Kontaktierungs-Abschnitte (16a, 16b) in höhenversetzten Kontaktbereich-Flächen (18a, 18b) angeordnet sind, wobei die Kontaktelemente (14a, 14b) im Kontaktierungs-Abschnitt (16a, 16b) als Einpress-Kontakte (22a, 22b, 26a, 26b, 28a, 28b) zum Einpressen in Einpress-Kontakt-Aufnahmen (24a, 24b, 38a, 38b, 44a, 44b) der Multilayerplatine (12a, 12b) ausgebildet sind, wobei
- in jeder Stufe des Reliefs die Kontaktelemente (16a, 16b) mit einer gleichen Länge aus der Stufe herausragen und nebeneinander entlang der Stufe in einer Verbindungslinie (40) angeordnet sind,
- die Einpress-Kontakte Signal-Einpress-Kontaktpaare (26a, 26b) bilden,
- den Einpress-Kontaktpaaren (26a, 26b) wenigstens ein benachbart in derselben Stufe angeordneter Abschirm-Einpress-Kontakt (28a, 28b) zugeordnet ist und
- die Abschirm-Einpress-Kontakte (28a, 28b) in Bezug auf die jeweils zugeordneten Signal-Einpress-Kontaktpaare (26a, 26b) mit einem Versatz (46) seitlich versetzt angeordnet sind, derart, dass sie nicht auf der Verbindungslinie (40) angeordnet sind.

2. Multilayerplatine zur Bestückung mit einem mehrpoligen Relief-Steckverbinder (10a, 10b), nach Anspruch 1, die ein treppenförmiges Relief mit mehreren höhenversetzten Kontaktbereich-Flächen (20a, 20b) aufweist, wobei in den Kontaktbereich-Flächen (20a, 20b) Kontakt-Aufnahmen angeordnet sind, die als Einpress-Kontakt-Aufnahmen (24a, 24b, 38a, 38b, 44a, 44b) ausgebildet sind, wobei
- in die Einpress-Kontakt-Aufnahmen (24a, 24b, 38a, 38b, 44a, 44b) elektrisch leitfähige erste und zweite Hülsen (32, 34) zur elektrischen Kontaktierung mit den Einpress-Kontakten (22a, 22b, 26a, 26b, 28a, 28b) der Relief-Steckverbinder (10a, 10b) eingebracht sind,
- sich wenigstens einige Einpress-Kontakt-Aufnahmen (24a, 24b) und die ersten Hülsen (32) über die gesamte Dicke (58a, 58b, 60a, 60b, 62a, 62b) der Multilayerplatine (12a, 12b) im Bereich der jeweiligen Kontaktbereich-Fläche (20a, 20b) erstrecken und zur Kontaktierung mit Abschirm-Einpress-Kontakten (28a, 28b) des mehrpoligen Relief-Steckverbinders (10a, 10b) vorgesehen sind,
- die Länge (36a, 36b) wenigstens einiger der zweiten Hülsen (34) auf einen vorgegebenen Wert festgelegt ist, die geringer als die Dicke der Multilayerplatine (12a, 12b) im Bereich der jeweiligen Kontaktbereich-Fläche (20a, 20b) ist, wobei die zweiten Hülsen zur Kontaktierung mit Signal-Einpress-Kontakten des mehrpoligen Relief-Steckverbinders (10a, 10b) vorgesehen sind.

3. Kombination aus wenigstens einem mehrpoligen Relief-Steckverbinder nach Anspruch 1 und einer Multilayerplatine nach Anspruch 2, wobei die Kontaktelemente (14a, 14b) des Relief-Steckverbinders (10a, 10b) im Kontaktierungs-Abschnitt (16a, 16b) in die Einpress-Kontakt-Aufnahmen (24a, 24b, 38a, 38b, 44a, 44b) der Multilayerplatine (12a, 12b) eingepresst sind.

4. Verfahren zur Herstellung einer Multilayerplatine nach Anspruch 2 zur Bestückung mit wenigstens einem Relief-Steckverbinder nach Anspruch 1, wobei
- Einpress-Kontaktelement-Aufnahmen (24a, 24b, 38a, 38b, 44a, 44b) angeordnet werden, die mittels Bohrungen durch die gesamte Dicke (48) der Multilayerplatine (12) hergestellt werden,
- die elektrisch leitfähigen ersten und zweiten Hülsen (32, 34) in die Bohrungen eingebracht werden,
- die Dicke der Multilayerplatine (12a, 12b) im Bereich der jeweiligen Kontaktbereich-Fläche (20a, 20b) von der Bestückungsseite (52a, 52b) mittels Bohren reduziert wird, so dass das treppenförmige Relief mit mehreren höhenversetzten Kontaktbereich-Flächen (20a, 20b) entsteht und
- von der Rückseite der Multilayerplatine (12a, 12b) wenigstens einige der zweiten Hülsen (34) entgegen der Bestückungsrichtung bis auf die vorgegebene Länge (36) ausgebohrt werden.

## Claims

1. Multipolar relief plug connector for making contact with a multi-layer circuit board (12a, 12b), which has a plurality of contact elements (14a, 14b), which protrude perpendicularly from the steps of a relief shaped like a staircase, such that the contacting portions (16a, 16b) of the contact elements (14a, 14b) are arranged in height-offset contact area surfaces (18a, 18b), wherein the contact elements (14a, 14b) in the contacting portion (16a, 16b) are formed as press-in contacts (22a, 22b, 26a, 26b, 28a, 28b) for pressing into press-in contact receptacles (24a, 24b, 38a, 38b, 44a, 44b) of the multi-layer circuit board (12a, 12b), wherein
- in each step of the relief, the contact elements (16a, 16b) protrude from the step with the same length and are arranged one next to the other along the step in a connection line (40),
- the press-in contacts form signal press-in contact pairs (26a, 26b),
- at least one shielding press-in contact (28a, 28b) that is arranged adjacently in the same step is allocated to the press-in contact pairs (26a, 26b) and
- the shielding press-in contacts (28a, 28b) are arranged laterally offset in relation to the respectively allocated signal press-in contact pairs (26a, 26b) with an offset (46) in such a way that they are not arranged on the connection line (40).

2. Multi-layer circuit board for equipping with a multipolar relief plug connector (10a, 10b) according to claim 1, said multi-layer circuit board having a relief shaped like a staircase having several height-offset contact area surfaces (20a, 20b), wherein contact receptacles are arranged in the contact area surfaces (20a, 20b), said contact receptacles being formed as press-in contact receptacles (24a, 24b, 38a, 38b, 44a, 44b), wherein
- electrically conductive first and second sleeves (32, 34) for making electrical contact with the press-in contacts (22a, 22b, 26a, 26b, 28a, 28b) of the relief plug connectors (10a, 10b) are introduced into the press-in contact receptacles (24a, 24b, 38a, 38b, 44a, 44b),
- at least some press-in contact receptacles (24a, 24b) and the first sleeves (32) extend across the entire thickness (58a, 58b, 60a, 60b, 62a, 62b) of the multi-layer circuit board (12a, 12b) in the region of the respective contact area surface (20a, 20b) and are provided for making contact with shielding press-in contacts (28a, 28b) of the multipolar relief plug connector (10a, 10b),
- the length (36a, 36b) of at least some of the second sleeves (34) is set to a predetermined value, said length (36a, 36b) being smaller than the thickness of the multi-layer circuit board (12a, 12b) in the region of the respective contact area surface (20a, 20b), wherein the second sleeves are provided for making contact with signal press-in contacts of the multipolar relief plug connectors (10a, 10b).

3. Combination of at least one multipolar relief plug connector according to claim 1 and a multi-layer circuit board according to claim 2, wherein the contact elements (14a, 14b) of the relief plug connector (10a, 10b) in the contacting portion (16a, 16b) are pressed into the press-in contact receptacles (24a, 24b, 38a, 38b, 44a, 44b) of the multi-layer circuit board (12a, 12b).

4. Method for producing a multi-layer circuit board according to claim 2 to be equipped with at least one relief plug connector according to claim 1,
wherein
- press-in contact element receptacles (24a, 24b, 38a, 38b, 44a, 44b) are arranged, which are produced by means of bores through the entire thickness (48) of the multi-layer circuit board (12),
- the electrically conductive first and second sleeves (32, 34) are introduced into the bores,
- the thickness of the multi-layer circuit board (12a, 12b) is reduced in the region of the respective contact area surface (20a, 20b) of the equipping side (52a, 52b) by means of bores, such that the relief shaped like a staircase having several height-offset contact area surfaces (20a, 20b) emerges, and
- at least some of the second sleeves (34) are drilled out from the rear side of the multi-layer circuit board (12a, 12b) against the equipping direction up to the predetermined length (36).

## Revendications

1. Connecteur enfichable en relief multipolaire destiné à la mise en contact avec une carte de circuits imprimés multicouche (12a, 12b), qui comporte une pluralité d'éléments de contact (14a, 14b), qui dépassent verticalement des marches d'un relief en forme d'escalier, de manière que ses parties de mise en contact (16a, 16b) sont disposées dans des surfaces de zone de contact (18a, 18b) décalées en hauteur, les éléments de contact (14a, 14b) étant conçus dans la partie de mise en contact (16a, 16b) sous forme de contacts d'insertion (22a, 22b, 26a, 26b, 28a, 28b) à insérer dans des logements de contact d'insertion (24a, 24b, 38a, 38b, 44a, 44b) de la carte de circuits imprimés multicouche (12a, 12b),
- les éléments de contact (16a, 16b) dépassant d'une même longueur de la marche au niveau de chaque marche du relief et étant disposés les uns à côté des autres le long de la marche dans une ligne de liaison (40),
- les contacts d'insertion créant des paires de contact d'insertion de signal (26a, 26b),
- au moins un contact d'insertion de blindage (28a, 28b) disposé au voisinage au niveau de la même marche étant associé aux paires de contact d'insertion (26a, 26b) et
- les contacts d'insertion de blindage (28a, 28b) étant décalés latéralement par rapport à chacune des paires de contact d'insertion de signal (26a, 26b) associée, avec un décalage (46) de manière qu'ils ne sont pas disposés sur la ligne de liaison (40).

2. Carte de circuits imprimés multicouche destinée à l'assemblage avec un connecteur enfichable en relief multipolaire (10, 10b), selon la revendication 1, qui comporte un relief en forme d'escalier avec plusieurs surfaces de zone de contact (20a, 20b) décalées en hauteur, des logements de contact étant disposés dans les surfaces de zone de contact (20a, 20b), qui sont conçus sous forme de logements de contact d'insertion (24a, 24b, 38a, 38b, 44a, 44b),
- des premières et deuxièmes cosses (32, 34) électriquement conductrices étant introduites dans les logements de contact d'insertion (24a, 24b, 38a, 38b, 44a, 44b) en vue de la mise en contact électrique avec les contacts d'insertion (22a, 22b, 26a, 26b, 28a, 28b) du connecteur enfichable en relief (10, 10b),
- au moins une partie des logements de contact d'insertion (24a, 24b) et les premières cosses (32) s'étendant sur toute l'épaisseur (58a, 58b, 60a, 60b, 62a, 62b) de la carte à circuits imprimés multicouche (12, 12b) dans la zone de la surface de zone de contact (20a, 20b) respective et étant prévues pour la mise en contact avec les contacts d'insertion de blindage (28a, 28b) du connecteur enfichable en relief multipolaire (10, 10b),
- la longueur (36a, 36b) d'au moins une partie des deuxièmes cosses (34) étant fixée à une valeur prédéterminée qui est inférieure à l'épaisseur de la carte de circuits imprimés multicouche (12a, 12b) dans la zone de la surface de zone de contact (20a, 20b) respective, les deuxièmes cosses étant prévues pour la mise en contact avec les contacts d'insertion de signal du connecteur enfichable en relief multipolaire (10, 10b).

3. Combinaison à base d'au moins un connecteur enfichable en relief multipolaire selon la revendication 1 et d'une carte de circuits imprimés multicouche selon la revendication 2, les éléments de contact (14a, 14b) du connecteur enfichable en relief (10, 10b) étant insérés dans la partie de mise en contact (16a, 16b) dans les logements de contact d'insertion (24a, 24b, 38a, 38b, 44a, 44b) de la carte de circuits imprimés multicouche (12a, 12b).

4. Procédé destiné à la fabrication d'une carte de circuits imprimés multicouche selon la revendication 2 en vue de l'assemblage avec au moins un connecteur enfichable en relief selon la revendication 1, dans lequel
- des logements d'éléments de contact d'insertion (24a, 24b, 38a, 38b, 44a, 44b) sont disposés, qui sont fabriqués au moyen d'alésages à travers l'épaisseur entière (48) de la carte de circuits imprimés multicouche (12),
- les premières et deuxièmes cosses électriquement conductrices (32, 34) sont introduites dans les alésages,
- l'épaisseur de la carte de circuits imprimés multicouche (12a, 12b) est réduite dans la zone de la surface de zone de contact (20a, 20b) respective depuis le côté d'assemblage (52a, 52b) au moyen d'alésages, de sorte que le relief en forme d'escalier est créé avec plusieurs surfaces de zone de contact (20a, 20b) décalées en hauteur et
- au moins une partie des deuxièmes cosses (34) est formée par des alésages depuis le côté arrière de la carte de circuits imprimés multicouche (12a, 12b), dans le sens contraire au sens d'assemblage, jusqu'à la longueur prédéterminée (36).
